# EUROPEAN PATENT APPLICATION

(11) **EP 3 297 037 A1**
(43) Date of publication of application: **21.03.2018**
(21) Application number: 16799035.7
(22) Date of filing: 04.02.2016
(51) Int. Cl.: H01L 31/0224

(54) **PREPARATION METHOD FOR SOLAR CELL PIECE UNIT AND SOLAR CELL MODULE**

(30) Priority: 22.05.2015 CN 201510267213; 31.12.2015 CN 201511027965
(71) Applicant: Suzhou Autoway System Co., Ltd., Suzhou, Jiangsu 215021 (CN)
(72) Inventor: LU, Qiankun, Suzhou, Jiangsu 215021 (CN)
(74) Representative: Rössler, Matthias
(86) International application number: PCT/CN2016/073452
(87) International publication number: WO 2016/188146

(57) **Abstract**

Provided are a solar cell module and a preparation method for a cell piece unit. The solar cell module comprises at least one solar cell piece unit group, each solar cell piece unit group comprising at least two bonded cell piece units. Each cell piece unit comprises a front surface and a back surface, wherein the front surface is provided with a power generation area and front main gate lines disposed at an edge of one side of the power generation area, a plurality of thin gate lines is disposed on the power generation area, and the thin gate lines are connected to the front main gate lines; and the back surface is provided with back main gate lines and an aluminum back field, and the front main gate lines and the back main gate lines are located on two opposite sides of the cell piece unit. The back main gate lines of one of the cell piece units are bonded and conductively connected to the front main gate lines of another cell piece unit. The cell module does not need a plurality of traditional front longitudinal main gate lines, and no longer needs a solder strip connecting process, thus reducing the coverage area of main gate lines, reducing the production cost and improving the efficiency of the solar cell module.

## Description

### TECHNICAL FIELD OF THE INVENTION

The present invention relates to the technical field of solar cell modules, and more particularly, to a method for preparing a cell piece unit and a solar cell module.

### BACKGROUND OF THE INVENTION

In recent years, the photovoltaic industry has seen rapid growth and development due to the wide application use of solar energy. In traditional solar cell module manufacturing process, due to the structural characteristics of the solar cell piece, a plurality of solar cell pieces and solder strips must be first soldered and series-connected together to form into a solar cell string. Subsequently, the solar cell strings and other components are assembled into one solar cell module unit.

Due to the presence of solder strips on the aforesaid traditional solar cell piece, the light-receiving area of the aforesaid traditional solar cell piece is sharply decreased, which in turn greatly reduces the effective power-generating area of the solar cell piece. Furthermore, the cell pieces are spaced apart from each other when formed into a series-connected cell string, which also greatly decreases the light-receiving area or the power-generating area. These two factors will cause low power generation efficiency of the traditional solar cell pieces.

### SUMMARY OF THE INVENTION

The purpose of the present invention is to solve the shortcomings of the prior art, by providing a solar cell module that have a larger light-receiving area, a higher output power and a higher power generation efficiency, and a method of preparation is provided thereof.

To achieve the above purpose, the present invention adopts the following technical solution:

A solar cell module, comprising at least one solar cell piece unit group that is arranged in the longitudinal or transverse direction; each solar cell piece unit group comprising at least two cell piece units; the cell piece units connected in one string are sequentially arranged in an overlapped manner; each cell piece unit comprises a front surface and a back surface, wherein the front surface is provided with a power generation area and front main gate lines disposed at an edge of one side of the power generation area; a plurality of thin gate lines is disposed on the power generation area, and the thin gate lines are connected to the front main gate lines; the back surface is provided with back main gate lines and an aluminum back field, and the front main gate lines and the back main gate lines are located on two opposite sides of the cell piece unit; the front main gate line and the back main gate line of each cell piece unit are respectively bonded and conductively connected to the back main gate line of one adjacent cell piece unit, and the front main gate line of the other adjacent cell piece unit.

On the said solar cell module, there's no main gate line exposed on the front surface that occupies the effective power generating area. Thus, the effective power-generating area of the whole solar cell module is significantly increased. Meanwhile, these solar cell pieces no longer needed to be connected via the solder strips, solving problems such as complicated process, high production cost and high occupation of effective power generation area.

In another aspect of the present invention, the solar cell module comprises at least two bonded cell piece units. The cell piece unit comprises a front surface and a back surface. The front surface is provided with a power generation area and a front main gate line disposed at an edge of one side of the power generation area. A plurality of thin gate lines is disposed on the power generation area, and the thin gate lines are connected to the front main gate line. The back surface is provided with a back main gate line and an aluminum back field. The front main gate line and the back main gate line are respectively located on two opposite sides of the cell piece unit. The back main gate line of one cell piece unit is bonded and conductively connected to the front main gate line of another cell piece unit.

In another aspect of the present invention, the front main gate line is connected to one end of the thin gate lines.

In another aspect of the present invention, the front main gate line of each cell piece unit is overlapped with the back main front lines of the adjacent cell piece units. The width of the overlapped area of two adjacent cell piece units is 1.2-2.5mm.

In another aspect of the present invention, at least two cell piece units are overlapped end to end to form a solar cell piece unit group. The solar cell module comprises at least one cell piece unit group, and each cell piece unit group comprises 2-80 solar cell piece units.

In another aspect of the present invention, the solar cell module comprises at least two cell piece unit groups. Interconnect busbars are disposed between the cell piece unit groups, through which the cell piece unit groups can be series-connected, parallel-connected, series-connected after a part of the cell piece unit groups are parallel-connected or parallel-connected after a part of the cell piece unit groups are series-connected.

In another aspect of the present invention, lead wires are disposed between the interconnect busbar and the cell piece unit group. A portion of the lead wire is electrically connected to the front main gate line or the back main gate line of the cell piece unit located at the outermost area of the cell piece unit group, and the other portion of the lead wire, which extends outwardly to a direction away from the cell piece unit group, is electrically connected to the interconnect busbar.

In another aspect of the present invention, the width of the connection portion of the interconnect busbar and the main gate line of the cell piece unit is 1-8mm.

In another aspect of the present invention, a portion of the interconnect busbar, which serves as the lead wire, is folded onto the back surface of the cell piece unit group. An insulating layer is disposed between the interconnect busbar and the back surface of the solar cell piece group, through which the interconnect busbar and the back surface of the solar cell piece group can be isolated.

In another aspect of the present invention, the interconnect busbar is provided with connection portions and extension portions. The connection portion and the front/back main gate line that is connected to the connection portion are disposed in the same direction. The extension portion is perpendicular to the connection portion, or forms a blunt angle or a sharp angle with the connection portion.

In another aspect of the present invention, each cell piece unit group has at least two connection portions with the lead wire of the front main gate line or that of the back main gate line. The extension portions are further connected to a same main lead wire.

In another aspect of the present invention, the main gate lines disposed at the outermost area of the same side of two adjacent cell piece unit groups have different polarities. Namely, the front main gate lines and the back main gate lines are arranged at intervals, wherein all the front main gate lines and the back main gate lines located on one side are connected to a same main lead wire, and all the front main gate lines located on the other side are connected to a front main gate line main lead wire. All the back main gate lines are connected to a back main gate line main lead wire. The front main gate line main lead wire and the back main gate line main lead wire serve as the master output lead wires of the solar cell module.

In another aspect of the present invention, lead wires connected to the front main gate line of the cell piece unit group or that connected to the back main gate line of the cell piece unit group are bent and folded onto the back surface of the cell piece unit group. The front main gate line main lead wire and the back main gate line main lead wire are disposed on the back surface of the cell piece unit group. Insulating components are disposed between the front main gate line main lead wire, the back main gate line main lead wire and the back surface of the cell piece unit group.

The present invention also provides a method for preparing the above cell piece unit, comprising the steps of:
Step 1: printing: printing the corresponding front screen-printed pattern and back screen-printed pattern on the front surface and the back surface of the silicon chip layer, wherein the front screen-printed pattern comprises thin gate lines and front main gate lines that are perpendicular to the thin gate lines, the front main gate lines are uniformly arranged at intervals along the length direction of the thin gate lines, and an edge of one side of the front screen-printed pattern is provided with front edge main gate lines;
   The back screen-printed pattern comprises back main gate lines and an aluminum back surface field; the back main gate lines and the front main gate lines are uniformly disposed at intervals in the same direction; an edge of one side of the back screen-printed pattern is provided with back edge main gate lines; the front edge main gate lines and the back edge main gate lines are respectively disposed on two opposite sides of the silicon chip layer;
Step 2: cutting: using a cutting apparatus to cut the solar cell piece along a cutting line, thereby forming a plurality of cell piece units, wherein the cutting line is overlapped with the edge of the front main gate line;
Step 3: bonding: applying an electrically conductive bonding material on the front main gate line of a first cell piece unit; subsequently, attaching the back main gate line of a second cell piece unit onto the front main gate line of the first cell piece unit, thereby bonding the two cell piece units; subsequently, bonding a third cell piece unit to the second cell piece unit in the same way; repeating the above step until all the cell piece units are electrically bonded together, thereby completing the preparation of a solar cell piece.

In another aspect of the present invention, the electrical conductive bonding material used in step 3 is either an electrically conductive adhesive or a soldering paste.

In another aspect of the present invention, all the cutting lines in step 2 are located on the same side of the front main gate lines, and are consistent with the outer edge of the front edge main gate lines.

Preparing the solar cell module and the cell piece unit of the present invention relates to a solar cell piece, which comprises an aluminum back field coating, a silicon chip layer and thin gate lines, with below features; the front surface of the solar cell piece is partitioned into at least two independent areas; for each independent areas, at least one front main gate line being disposed at the edge of one side of each area or a position close to the edge; all the thin gate lines on the front surface of this area are electrically connected to the front main gate lines of this area.. The said independent area is a cell piece unit, which can be used independently after being cut, or can be connected to other cell piece units in series or in parallel through conductive wires or lead wires without being cut.

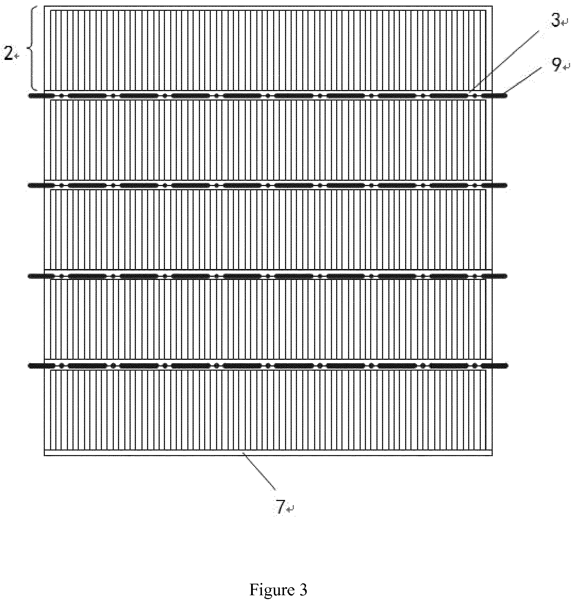

The aforesaid solar cell piece is an essential component for preparing a solar cell module. In a traditional process, the solar cell piece comprises a silicon chip layer, an aluminum back field coating, front thin gate lines, and three or four longitudinal main gate lines. When preparing a solar cell module, the main gate lines of a plurality of solar cell pieces need to be soldered and connected in series by means of solder strips. Meanwhile, all energy conversion units of a traditional solar cell piece are usually connected into an integral body through the thin gate lines and the main gate lines. Each main gate line simultaneously collects the current of the energy conversion units on the left and right sides. The main gate lines of the solar cell piece of the present invention are transversely arranged, thereby partitioning the solar cell piece into at least two independent areas. Each area is provided with one front main gate line, and each main gate line will only collect the current of the energy conversion units in its own area (located on one side of the front main gate line). In order to improve the energy conversion efficiency, such an area is preferred to be as small as possible, so that, the path from the thin gate lines to the main gate line is shorter, thus improving the collection and conversion efficiency. Being limited by the production process and cost, the number of the independent areas is preferred to be between two to six. According to the actual requirement, a solar cell piece can be provided with seven or more independent areas. In the process of preparing a solar cell module, the solar cell piece of the present invention has a higher flexibility. For instance, (1) each area can be cut into a plurality of independent solar cell piece units. The solar cell piece units can then be connected in series, and the two ends of the solar cell piece units can be series-connected in a staggered and shingled overlapping manner. When the main gate line of each solar cell piece unit is disposed at the top of each solar cell piece unit, the upper edge of each lower cell piece unit is exactly overlapped with the lower edge of each upper cell piece unit as these cell piece units are arranged from top to bottom and the main gate line of each lower cell piece unit is exactly covered by the lower edge of each upper cell piece unit, enabling the main gate lines of each lower cell piece unit to be connected to the back positive electrode of each upper cell piece unit. In this way, all the cell piece units are series-connected by repeating the above step. Thus, the main gate lines will no longer appear on the front surface of the solar cell module and this eliminates the spaces occupied by the main gate lines. In such a configuration, the effective power-generating area of the whole solar cell module is significantly increased. Meanwhile, it's unnecessary to connect the solar cell pieces via the solder strips, thereby solving problems such as complicated process, high production cost and wastage of effective power-generating area. (2) When the cell piece units are arranged in a staggered and shingled overlapped manner, and the front main gate line of a next cell piece unit is insulated from the back positive electrodes of a previous cell piece unit, the front main gate lines of all the cell piece units are connected on the side surface or on the back surface, and the back positive electrodes of all the cell piece units are connected together. After extracting the back positive electrodes, a solar cell module having a parallel structure (shown in Figure 3) can be achieved. Thus, the circuit structure of the solar cell module can have more combinations. (3) The above two connection methods can be freely combined to form various circuit structures of the solar cell module. (4) The front main gate line in one area can be connected to the back electrodes in another area by means of the connecting wires. Thus, all the areas of the solar cell piece can be first series-connected, parallel-connected or series-parallel connected without being cut. Subsequently, a plurality of solar cell pieces is connected in series, thereby completing the assembly of a solar cell module.

In another aspect of the present invention, the back surface of the solar cell piece corresponds to the front surface area. A back main gate line is disposed at an edge of one side or a position close to the edge which is opposite to the main gate line that is disposed on the corresponding area of the front surface of the solar cell piece. The back main gate line is electrically connected to the back electrodes on the corresponding area of the solar cell piece.

In another aspect of the present invention, an isolation zone, which enables the adjacent areas to be electrically isolated, is provided between adjacent areas on the front surface of the solar cell piece.

In another aspect of the present invention, a portion of the back surface of the solar cell piece, which corresponds to the position of the isolation zone of the front surface, is not provided with the aluminum back field coating.

In another aspect of the present invention, a portion of the back surface of the solar cell piece, which corresponds to the position located between the front surface areas, is provided with line-shaped or strip-like separating lines having no aluminum back field coating.

In another aspect of the present invention, the front main gate lines of the two outermost areas on the front surface of the solar cell piece are disposed at an edge or a position close to the edge of the outermost area of the solar cell piece.

In another aspect of the present invention, the front main gate line comprises soldering portions and connecting portions. The width of the soldering portion is greater than that of the connecting portion. The soldering portions are connected through the connecting portions. The front main gate line is a single through gate line, or two or more separated gate lines.

In another aspect of the present invention, transverse thin gate lines, through which the adjacent thin gate lines are connected, are perpendicular to the thin gate lines, and are disposed between the thin gate lines.

The present invention also provides a method for preparing a solar cell piece of claim 1 or 2, comprising the following steps:
Step 1: testing the silicon chip layer;
Step 2: texturing the surface of the silicon chip layer;
Step 3: performing a diffusion to form a P-N Junction;
Step 4: removing the phosphorus silicon glass;
Step 5: removing the P-N junction on the edges of the cell piece;
Step 6: preparing an antireflection film;
Step 7: preparing the positive and negative electrodes, which comprises the steps of:
   a) printing the front electrodes: printing the corresponding front screen-printed pattern on the front surface of the silicon chip layer, wherein the front screen-printed pattern separates the solar cell piece into at least two areas, and each area comprises the thin gate lines and the front main gate line that is connected to the thin gate lines, the front main gate lines in different areas being arranged in parallel at intervals, and the main gate lines of the two edge areas of the solar cell piece being respectively disposed on the edge or close to the edge of the solar cell piece;
   b) printing the aluminum back surface field: printing the corresponding back screen-printed pattern on the back surface of the silicon chip layer, wherein the back screen-printed pattern comprises the back main gate lines and the aluminum back surface field, the back main gate line and the front main gate line being arranged in parallel, each area corresponding to the front surface being provided with a back main gate line, the back main gate line in each area being disposed on one side far from the front main gate line.
Step 8: sintering.

The present invention also provides a solar cell module comprising at least two bonded cell piece units. The cell piece unit comprises a front surface and a back surface. The front surface is provided with a power generation area and a front main gate line disposed at an edge of one side of the power generation area. A plurality of thin gate lines is disposed on the power generation area, and the thin gate lines are connected to the front main gate line. The back surface is provided with a back main gate line and an aluminum back field, and the front main gate line and the back main gate line are respectively located on two opposite sides of the cell piece unit. The back main gate line of one cell piece unit is bonded and conductively connected to the front main gate line of another cell piece unit. The aforesaid cell piece units are formed by cutting the solar cell piece into a plurality of independent areas.

In another aspect of the present invention, the front main gate line is connected to one end of the thin gate lines.

A method for preparing the cell piece unit of the present invention, comprising the steps of:
Step 1: printing: printing the corresponding front screen-printed pattern and back screen-printed pattern on the front surface and the back surface of the silicon chip layer, wherein the front screen-printed pattern comprises thin gate lines and front main gate lines that are perpendicular to the thin gate lines, the front main gate lines are uniformly arranged at intervals along the length direction of the thin gate lines, and an edge of one side of the front screen-printed pattern is provided with front edge main gate lines;
   The back screen-printed pattern comprises back main gate lines and an aluminum back surface field; the back main gate lines and the front main gate lines are uniformly disposed at intervals in the same direction; an edge of one side of the back screen-printed pattern is provided with back edge main gate lines; the front edge main gate lines and the back edge main gate lines are respectively disposed on two opposite sides of the silicon chip layer;
Step 2: cutting: using a cutting apparatus to cut the solar cell piece along a cutting line, thereby forming a plurality of cell piece units, wherein the silicon chip layer is cut into a plurality of independent cell piece units along the cutting line;
Step 3: bonding: applying an electrically conductive bonding material on the front main gate line of a first cell piece unit; subsequently, attaching the back main gate line of a second cell piece unit onto the front main gate line of the first cell piece unit, thereby bonding the two cell piece units; subsequently, bonding a third cell piece unit to the second cell piece unit in the same way; repeating the above step until all the cell piece units are electrically bonded together, thereby completing the preparation of a solar cell piece.

In another aspect of the present invention, the conductive bonding material used in step 3 is an electrically conductive adhesive, a soldering paste, an electrically conductive tape, or a solder strip.

In another aspect of the present invention, all the cutting lines in step 2 are located on the same side of the front main gate lines, and are consistent with the outer edge of the front edge main gate lines.

### BRIEF DESCRIPTION OF THE DRAWINGS

To clearly expound the technical solution of the present invention, the drawings and embodiments are hereinafter combined to illustrate the present invention. Obviously, the drawings are merely some embodiments of the present invention and those skilled in the art can associate themselves with other drawings without paying creative labor.
Figure 1 is a structural diagram illustrating the front screen-printed pattern of the solar cell piece of the present invention;
Figure 2 is a structural diagram illustrating the back screen-printed pattern of the solar cell piece of the present invention;
Figure 3 is a schematic diagram illustrating the cutting process of the solar cell piece of the present invention;
Figure 4 is a structural diagram illustrating the front surface of the cell piece unit of the solar cell piece of the present invention;
Figure 5 is a structural diagram illustrating the back surface of the cell piece unit of the solar cell piece of the present invention;
Figure 6 is a schematic diagram illustrating the bonding process of the solar cell piece of the present invention;
Figure 7 is another schematic diagram illustrating the bonding process of the solar cell piece of the present invention;
Figure 8 is a schematic diagram illustrating the finished product formed by two bonded cell piece units in the process of preparing the solar cell piece of the present invention;
Figure 9 is a structural diagram of the solar cell piece of the present invention;
Figure 10 is a structural diagram of the solar cell module of the present invention;
Figure 11 is another structural diagram of the solar cell module of the present invention;
Figure 12 is a schematic diagram illustrating a connection state of the lead wire and the main gate line;
Figure 13 is a schematic diagram illustrating a connection state of the lead wire and the interconnect busbar.
Figure 14 is a schematic diagram illustrating the lead wire and the interconnect busbar that are folded onto the back surface of the solar cell module; and
Figure 15 is an example illustrating a connection way between the cell piece units.

### Marking Instructions of the Drawings:

1.Cell Piece Unit , 2, Power Generation Area , 3, Front Main Gate Line , 4, Thin Gate Line , 5, Back Main Gate Line , 6, Aluminum Back Surface Field , 7, Front Edge Main Gate Line , 8, Back Edge Main Gate Line , 9, Cutting Line , 10, Conductive Bonding Material 101, Cell Piece Unit Group 301, Lead Wire , 302, Interconnect Busbar , 304, Insulating Layer , 3011, Connection Portion , 3012, Extension portion

### DETAILED DESCRIPTION OF THE INVENTION

The embodiments described in the present invention will now be described with reference to the accompanying drawings of the present invention, and it will be apparent that the described embodiments are merely part of the examples of the invention and are not intended to be exhaustive. All other embodiments obtained by those of ordinary skill in the art without making creative work are within the scope of the present invention, based on embodiments in the present invention.

Drawings and detailed embodiments are combined hereinafter to elaborate the technical principles of the present invention.

The present invention provides a solar cell module, which comprises at least one solar cell piece unit group that is arranged in the longitudinal or transverse direction; each solar cell piece unit group comprising at least two cell piece units; the cell piece units connected in one string are sequentially arranged in an overlapped manner; each cell piece unit comprises a front surface and a back surface, wherein the front surface is provided with a power generation area and front main gate lines disposed at an edge of one side of the power generation area; a plurality of thin gate lines is disposed on the power generation area, and the thin gate lines are connected to the front main gate lines; the back surface is provided with back main gate lines and an aluminum back field, and the front main gate lines and the back main gate lines are located on two opposite sides of the cell piece unit; the front main gate line and the back main gate line of each cell piece unit are respectively bonded and conductively connected to the back main gate line of one adjacent cell piece unit, and the front main gate line of the other adjacent cell piece unit.

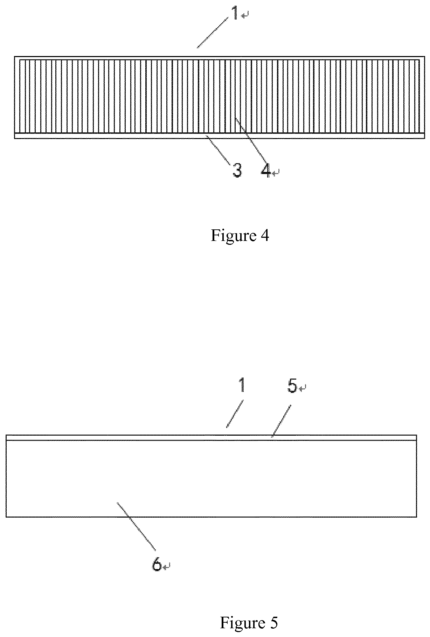

Figures 4 and 5 show a cell piece unit of the present invention. The front surface of the cell piece unit 1 shown in Figure 4 comprises thin gate lines 4 and a front main gate line 3 that is perpendicular to the thin gate lines 4. The front main gate line 3 is disposed at an edge of one side of the cell piece unit.

As shown in Figure 5, the back surface of the cell piece unit 1 comprises a back main gate line 5 and an aluminum back surface field. The back main gate line 5 is disposed in the same direction with the front main gate line 3, and is disposed at an edge of the opposite side of the front main gate line 3.

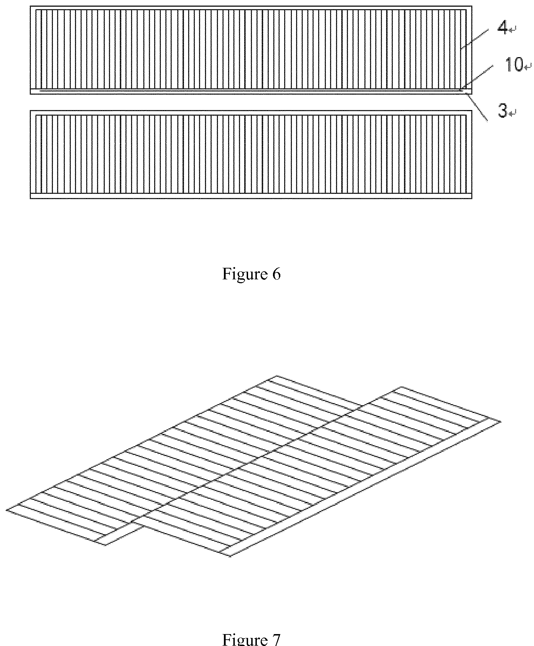

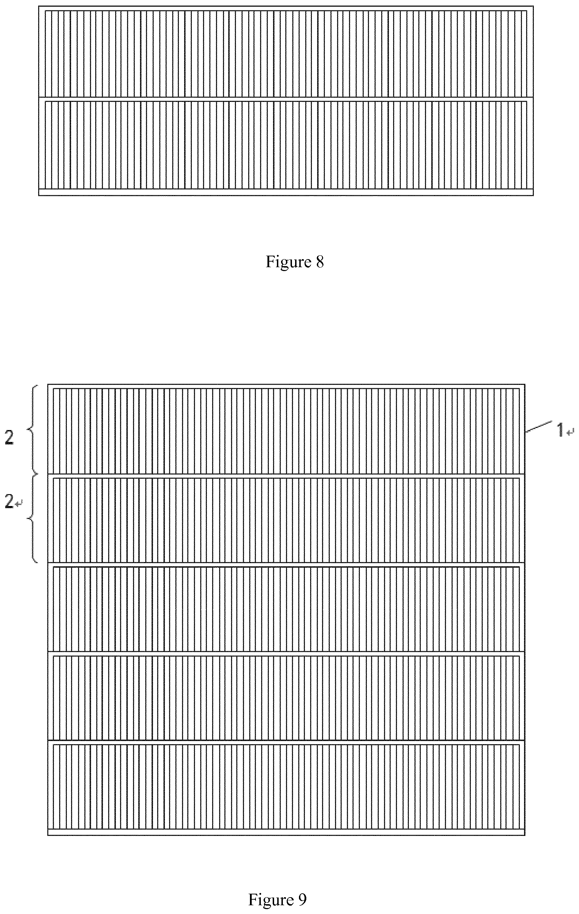

Figure 6 shows two cell piece units that are prepared to be connected in series. The conductive bonding material 10 is first applied on the front main gate line 3 at the lower edge of the upper cell piece unit. Subsequently, the upper edge of the next cell piece unit is overlapped with the lower edge of the previous cell piece unit, allowing the back main gate line of the next cell piece unit to be bonded and conductively connected to the front main gate line of the previous cell piece unit. Thus, the upper and lower cell piece units can be connected in series. Figures 7 and 8 show two cell piece units that is connected in series and Figure 9 shows a plurality of cell piece units that are connected in series. As shown in Figure 9, five cell piece units are connected in series, and are sequentially arranged from top to bottom in an overlapped manner. The back main gate line of each cell piece unit is disposed at an edge of one side of the upper portion of the back surface, and the front main gate line is disposed at an edge of one side of the lower portion of each cell piece unit. The upper edge of the next cell piece unit is overlapped with the lower edge of the previous cell piece unit, allowing the back main gate line of the next cell piece unit to be bonded and conductively connected to the front main gate line of the previous cell piece unit. Thus, a plurality of upper and lower cell piece units is connected in series, thereby forming a cell piece unit group. The number of the cell piece units in one cell piece unit group can be of any quantity. Normally, a cell piece unit group comprises 2-80 cell piece units. The back main gate line of the cell piece unit located on the top of each cell piece unit group, and the front main gate line of the cell piece unit located at the bottom of each cell piece unit group form the positive and negative electrodes of the whole cell piece unit group, which can be electrically connected to the lead wire and the interconnecting busbar, or can be connected to other cell piece unit groups in series or in parallel to finally formed into a solar cell module.

As described above, the solar cell module comprises at least two bonded cell piece units. The cell piece unit comprises a front surface and a back surface. The front surface is provided with a power generation area and front main gate lines disposed at an edge of one side of the power generation area. A plurality of thin gate lines is disposed on the power generation area, and the thin gate lines are connected to the front main gate lines. The back surface is provided with back main gate lines and an aluminum back field, and the front main gate lines and the back main gate lines are respectively located on two opposite sides of the cell piece unit. The back main gate lines of one cell piece unit are bonded and conductively connected to the front main gate line of another cell piece unit. In practical use, the front main gate lines, the back main gate lines and the cell piece unit groups can be electrically connected through soldering process or other electrical connecting methods.

In normal circumstances, the front main gate line is connected to one end of the thin gate lines, and the effective area of the cell piece unit is covered by the thin gate lines. In order to improve the collecting efficiency and reduce the coverage area, the screen-printed pattern sometimes simultaneously comprises thin gate lines disposed in both longitudinal and transverse directions, thereby preventing the effective power generation area from being reduced due to one broken thin gate line. After the electrical current is being collected by the thin gate lines, the electrical current can be output by the front main gate line disposed at an edge of the cell piece unit. After adopting the above arrangement, the effective power generation area of the front surface of the solar cell module is no longer occupied by the main gate lines, thus greatly improving the power generation efficiency. With this, it is also not required to solder the cell piece units via solder strips, greatly simplifying the production process and reducing the production cost.

To further satisfy the requirements of electrical connection and reduce the coverage area, the front main gate line of each cell piece unit is overlapped with the back main gate lines of adjacent cell piece units. The width of the overlapped area of two adjacent cell piece units is 1.2-2.5mm.

The width of the overlapped area is the sum of the width of the main gate line and that of the isolation area on each side of the main gate line. In one embodiment of the present invention, the width of the overlapped area is 2mm, wherein the width of the main gate line is designed to be 1mm, and the width of the isolation area on each side of the main gate line is 0.5mm. The isolation areas respectively belong to the upper and lower solar cell units. The reasonable adhesive-dispensing aperture is 0.3-0.5mm. The main gate lines having a width of 1mm are applied with the conductive bonding material. After being bonded at a high temperature, the material composite in the conductive adhesive or the soldering paste are diffused and coated onto the main gate lines. The isolation areas are used to prevent the conductive adhesive or the soldering paste from being diffused further or prevent overflowing. Due to the restrictive relation between the dispensing precision and speed, the dispensing speed and stability can be affected when the dispensing aperture becomes narrower. Presently, the minimum aperture is 0.3mm. The offset of the dispensing center line is +/-0.05mm, and the width of the main gate line is preferred to be not less than 0.6mm. The offset of the laser slicing center line is +/-0.1mum, and the width of the isolation area used for cutting process is preferred to be not less than 0.6mm. The total width of the overlapped area is equal to or greater than 1.2mm. In the prior art, an overlapped area having a width of 2mm can be stably achieved, which can be maximized further to 2.5mm. However, a width greater than 2.5mm does not serve much purpose, as it is merely a waste of the solar cell piece.

In practical use, at least two cell piece units are overlapped end to end to form a cell piece unit group. The aforesaid solar cell module comprises at least one cell piece unit group (each solar cell module normally comprises three to six strings of cell piece unit groups that are arranged side-by-side), and each cell piece unit group comprises 2-50 cell piece units.

Normally, a solar cell module comprises at least two strings of cell piece unit groups and between the cell piece unit groups, interconnecting busbars are used to connect the cell piece unit groups through which the cell piece unit groups are series-connected, parallel-connected, series-connected after a part of the cell piece unit groups are parallel-connected or parallel-connected after a part of the cell piece unit groups are series-connected.

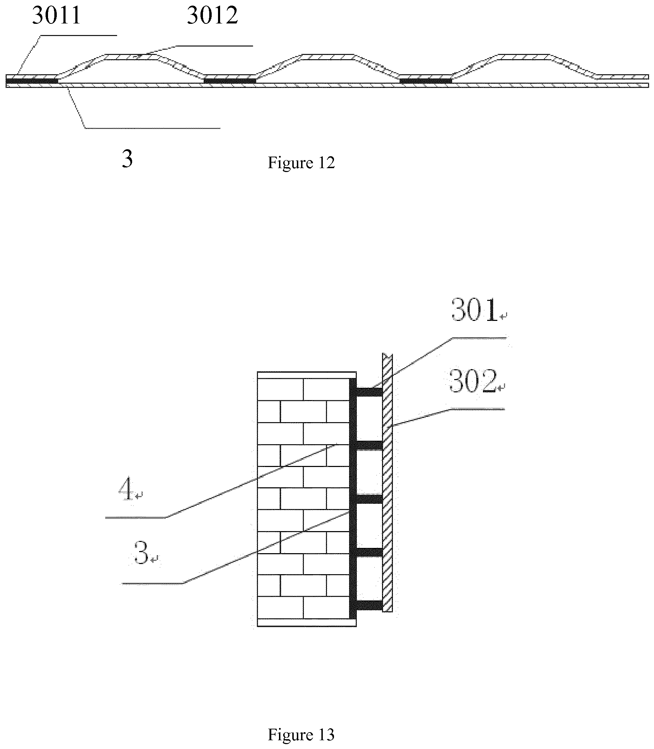

In some embodiments, lead wires are provided between the interconnect busbars and the cell piece unit groups. As shown in Figure 12, a part of the lead wire is electrically connected (the part marked as 3011 in Figure 12 is the portion where the lead wire is connected to the front main gate line or the back main gate line) to the front main gate line 3 or the back main gate line of a cell piece unit located at the outermost area of the cell piece unit group. The other part of the lead wire extends outwardly (the part marked as 3012 in Figure 12 is an extension portion, which is used to connect the interconnect busbar; sometimes, the extension portion can be used as a interconnect busbar, or the interconnect busbar and the lead wire is formed in single piece) to a direction away from the cell piece unit group, and is electrically connected to the interconnect busbar. The embodiment shown in Figure 12 is an example of the interconnect busbar and the lead wire are formed in single piece. The interconnect busbar is provided with a connection portion (marked as 3011) and an extension portion (marked as 3012). The connection portion and the front/back main gate line that is connected to the connection portion are disposed in the same direction. The extension portion is perpendicular to the connection portion, or forms a blunt angle or a sharp angle with the connection portion.

In some embodiments, when the interconnect busbar is directly connected to the front main gate line or the back main gate line, the width of the connection portion between the interconnect busbar and the main gate line of the cell piece unit is 1-8mm. When lead wires are provided between the interconnect busbars and the cell piece unit groups, the width of the connection portion between the lead wire and the main gate line of the cell piece unit is 1-8mm, which is the width in the length direction of the front main gate line or the back main gate line that is covered by the interconnect busbar or the lead wire. Thus, a same front main gate line or back main gate line can be provided with one, two, three or more connection portions with the lead wires or the interconnect busbar, which can reduce the usage of the interconnect busbar or the lead wire on the basis of ensuring sufficient current transmission capacity is achieved. Thus, the production cost can be saved. As shown in Figure 13, five lead wires 301 are provided between the interconnect busbar 302 and the front main gate line 3, and the portion marked as 4 in Figure 13 is a thin gate line.

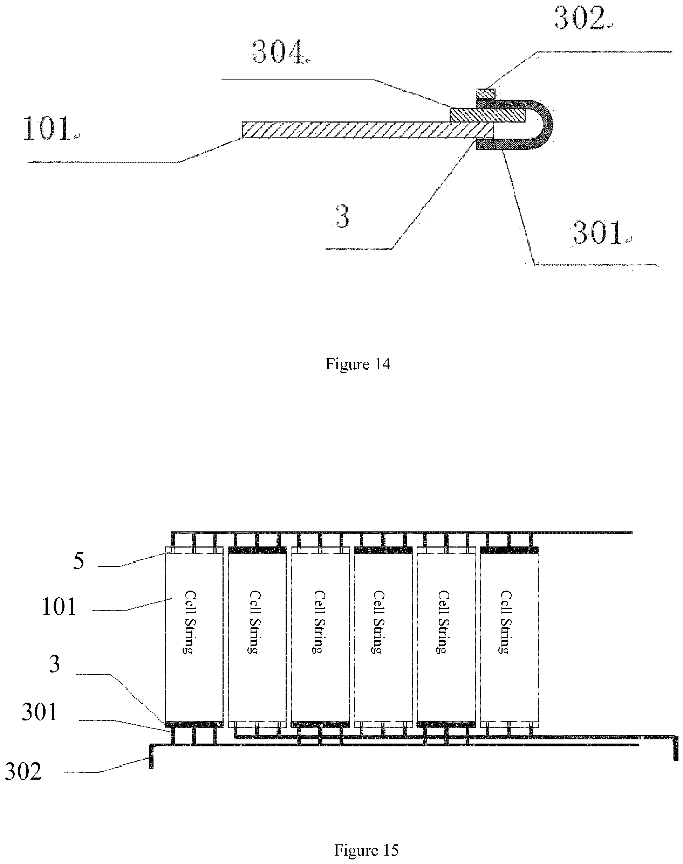

In some embodiment, when the interconnect busbar and the lead wires are formed in single piece, a portion of the interconnect busbar, which is used as the lead wire, is folded onto the back surface of the cell piece unit group. Meanwhile, an insulating layer is disposed between the interconnect busbar and the back surface of the solar cell piece, thereby isolating the interconnect busbar from the back surface. As shown in Figure 14, when the interconnect busbar and the lead wires are independently prepared, the front main gate line 3 disposed at the outermost area of the cell piece unit group 101 is connected (the front surface and the back surface of the cell piece unit group is inverted in this figure) to the lead wire 301, which is subsequently connected to the interconnect busbar 302. In practical use, the lead wire 301 is folded together with the interconnect busbar 302 onto the back surface of the cell piece unit group, and an insulating layer 304 is disposed between the back surface of the solar cell piece and the lead wire 301 and the interconnect busbar 302 that are folded together. Thus, the front surface area that is covered by the lead wire and the interconnect busbar can be effectively reduced, helping to reduce the size of the solar cell module. Meanwhile, the appearance of the solar cell module can be more appealing.

Normally, each string of cell piece unit group is provided with at least two connection portions with the front main gate line lead wire or the back main gate line lead wire. The extension portions are connected to the same main lead wire. As shown in Figure 13, the number of the connection portions (marked as 301 in Figure 13) is five.

In some embodiments, when assembling a solar cell module, the main gate lines disposed at the outermost area of the same side of two adjacent cell piece unit groups have different polarities. Namely, the front main gate lines and the back main gate lines are arranged at intervals, meaning that the adjacent cell piece unit groups are inverted to each other, which is similar to dry cells that are arranged in parallel at intervals with their polarities being inverted to each other. All the front main gate lines and the back main gate lines located on one side are connected to a same main lead wire, all the front main gate lines located on the other side are connected to a front main gate line main lead wire, and all the back main gate lines are connected to a back main gate line main lead wire. The front main gate line main lead wire and the back main gate line main lead wire serve as the master output lead wires of the solar cell module. As shown in Figure 15, the polarities of the cell piece unit groups (cell strings) are inverted to each other at intervals. Figure 15 shows six strings of cell piece unit groups 101, wherein the upper end output located at the leftmost area of the cell piece unit group 101 is the back main gate line 5, and the lower end is the front main gate line 3. The polarities of the cell piece unit groups adjacent to the right side are inverted to each other, meaning that the upper end is the front main gate line and the lower end is the back main gate line. In such a way, the front main gate line disposed at the upper end is electrically connected to the back main gate line, and the front main gate line disposed at the lower end is electrically connected to the interconnect busbar 302 through the lead wires 301, which serves as an output electrode of the solar cell module. Meanwhile, the back main gate line disposed at the lower end is electrically connected to the interconnect busbar through other lead wires, which serves as the other output electrode of the solar cell module. Figure 15 merely shows an example of a connection method of the cell piece unit groups, Other connection methods can be easily associated by those skilled in this art, which is not described further.

As described above, lead wires connected to the front main gate line of the cell piece unit group or lead wires connected to the back main gate line of the cell piece unit group are bent and folded onto the back surface of the cell piece unit group. The front main gate line main lead wire and the back main gate line main lead wire are disposed on the back surface of the cell piece unit group, thereby reducing the front surface area of the solar cell module that is covered by the lead wires and the interconnect busbar. Thus, the size of the solar cell module can be reduced. Insulating components are disposed between the front main gate line main lead wire, the back main gate line main lead wire and the back surface of the cell piece unit group

The present invention also provides a method for preparing the above cell piece unit, comprising the steps of:
Step 1: printing: printing the corresponding front screen-printed pattern and back screen-printed pattern on the front surface and the back surface of the silicon chip layer, wherein the front screen-printed pattern comprises thin gate lines and front main gate lines that are perpendicular to the thin gate lines, the front main gate lines are uniformly arranged at intervals along the length direction of the thin gate lines, and an edge of one side of the front screen-printed pattern is provided with front edge main gate lines;
   The back screen-printed pattern comprises back main gate lines and an aluminum back surface field; the back main gate lines and the front main gate lines are uniformly disposed at intervals in the same direction; an edge of one side of the back screen-printed pattern is provided with back edge main gate lines; the front edge main gate lines and the back edge main gate lines are respectively disposed on two opposite sides of the silicon chip layer;
Step 2: cutting: using a cutting apparatus to cut the solar cell piece along a cutting line, thereby forming a plurality of cell piece units, wherein the cutting line is overlapped with the edge of the front main gate line;
Step 3: bonding: applying an electrically conductive bonding material on the front main gate line of a first cell piece unit; subsequently, attaching the back main gate line of a second cell piece unit onto the front main gate line of the first cell piece unit, thereby bonding the two cell piece units; subsequently, bonding a third cell piece unit to the second cell piece unit in the same way; repeating the above step until all the cell piece units are electrically bonded together, thereby completing the preparation of a solar cell piece.

In another aspect of the present invention, the electrically conductive bonding material used in step 3 is either an electrical conductive adhesive or a soldering paste.

In another aspect of the present invention, all the cutting lines in step 2 are located on the same side of the front main gate lines, and are consistent with the outer edge of the front edge main gate lines.

Preparing the solar cell module and the cell piece unit of the present invention relates to a solar cell piece, which comprises an aluminum back field coating, a silicon chip layer and thin gate lines. A front surface of the solar cell piece is partitioned into at least two independent areas, at least one front main gate line being disposed at an edge of one side of each area or a position close to the edge, all the thin gate lines on the front surface of this area being electrically connected to the front main gate lines of this area. The said independent area is a cell piece unit, which can be used independently after being cut, or can be connected to other cell piece units in series or in parallel through guide lines or lead wires without being cut.

The aforesaid solar cell piece is an essential component for preparing a solar cell module. In a traditional process, the solar cell piece comprises a silicon chip layer, an aluminum back field coating, front thin gate lines, and three or four longitudinal main gate lines. When preparing a solar cell module, the main gate lines of a plurality of solar cell pieces need to be soldered and connected in series by means of solder strips. Meanwhile, all energy conversion units of a traditional solar cell piece are usually connected into an integral body through the thin gate lines and the main gate lines. Each main gate line simultaneously collects the current of the energy conversion units on the left and right sides. The main gate lines of the solar cell piece of the present invention are transversely arranged, thereby partitioning the solar cell piece into at least two independent areas. Each area is provided with one front main gate line, and each main gate line will only collect the current of the energy conversion units from its own area (located on one side of the front main gate line). In order to improve the energy conversion efficiency, such an area is preferred to be as small as possible. Thus, the path from the thin gate lines to the main gate line can be shorter, making the collection and conversion efficiency to be higher. Being limited by the production process and cost, the number of the independent areas is preferred to be between two to six. According to the actual requirement, a solar cell piece can be provided with more than seven independent areas. In the process of preparing a solar cell module, the solar cell piece of the present invention has a higher flexibility. For instance, (1) each area can be cut into a plurality of independent solar cell piece units. The solar cell piece units can then be connected in series, and the two ends of the solar cell piece units can be series-connected in a staggered and shingled overlapping manner. When the main gate line of each solar cell piece unit is disposed at the top of each solar cell piece unit, the upper edge of each lower cell piece unit is exactly overlapped with the lower edge of each upper cell piece unit as these cell piece units are arranged from top to bottom and the main gate line of each lower cell piece unit is exactly covered by the lower edge of each upper cell piece unit, enabling the main gate lines of each lower cell piece unit to be connected to the back positive electrode of each upper cell piece unit. In this way, all the cell piece units are series-connected by repeating the above step. Thus, the main gate lines will no longer appear on the front surface of the solar cell module and this eliminates the spaces occupied by the main gate lines. In such a configuration, the effective power-generating area of the whole solar cell module is significantly increased. Meanwhile, it's unnecessary to connect the solar cell pieces via the solder strips, thereby solving problems such as complicated process, high production cost and wastage of effective power-generating area (2), When the cell piece units are arranged in a staggered and shingled overlapped manner, and the front main gate line of a next cell piece unit is insulated from the back positive electrodes of a previous cell piece unit, the front main gate lines of all the cell piece units are connected on the side surface or on the back surface, and the back positive electrodes of all the cell piece units are connected together. After extracting the back positive electrodes, a solar cell module having a parallel structure (shown in Figure 3) can be achieved. Thus, the circuit structure of the solar cell module can have more combinations. (3), The above two connection methods can be freely combined to form various circuit structures of the solar cell module. (4), The front main gate line in one area can be connected to the back electrodes in another area by means of the connecting wires. Thus, all the areas of the solar cell piece can be first series-connected, parallel-connected or series-parallel connected without being cut. Subsequently, a plurality of solar cell pieces is connected in series, thereby completing the assembly of a solar cell module.

In another aspect of the present invention, the back surface of the solar cell piece corresponds to the front surface area. A back main gate line is disposed at an edge of one side or a position close to the edge which is opposite to the main gate line that is disposed on the corresponding area of the front surface of the solar cell piece. The back main gate line is electrically connected to the back electrodes on the corresponding area of the solar cell piece.

In another aspect of the present invention, an isolation zone, which enables the adjacent areas to be electrically isolated, is provided between adjacent areas on the front surface of the solar cell piece.

In another aspect of the present invention, a portion of the back surface of the solar cell piece, which corresponds to the position of the isolation zone of the front surface, is not provided with the aluminum back field coating.

In another aspect of the present invention, a portion of the back surface of the solar cell piece, which corresponds to the position located between the front surface areas, is provided with line-shaped or strip-like separating lines having no aluminum back field coating.

In another aspect of the present invention, the front main gate lines of the two outermost areas on the front surface of the solar cell piece are disposed at an edge or a position close to the edge of the outermost area of the solar cell piece.

In another aspect of the present invention, the front main gate line comprises soldering portions and connecting portions. The width of the soldering portion is greater than that of the connecting portion. The soldering portions are connected through the connecting portions. The front main gate line is a single through gate line, or two or more separated gate lines.

In another aspect of the present invention, transverse thin gate lines, through which the adjacent thin gate lines are connected, are perpendicular to the thin gate lines, and are disposed between the thin gate lines.

The present invention also provides a method for preparing a solar cell piece of claim 1 or 2, comprising the following steps:
Step 1: testing the silicon chip layer;
Step 2: texturing the surface of the silicon chip layer;
Step 3: performing a diffusion to form a P-N Junction;
Step 4: removing the phosphorus silicon glass;
Step 5: removing the P-N junction on the edges of the cell piece;
Step 6: preparing an antireflection film;
Step 7: preparing the positive and negative electrodes, which comprises the steps of:
   a) printing the front electrodes: printing the corresponding front screen-printed pattern on the front surface of the silicon chip layer, wherein the front screen-printed pattern separates the solar cell piece into at least two areas, and each area comprises the thin gate lines and the front main gate line that is connected to the thin gate lines, the front main gate lines in different areas being arranged in parallel at intervals, and the main gate lines of the two edge areas of the solar cell piece being respectively disposed on the edge or close to the edge of the solar cell piece;
   b) printing the aluminum back surface field: printing the corresponding back screen-printed pattern on the back surface of the silicon chip layer, wherein the back screen-printed pattern comprises the back main gate lines and the aluminum back surface field, the back main gate line and the front main gate line being arranged in parallel, each area corresponding to the front surface being provided with a back main gate line, the back main gate line in each area being disposed on one side far from the front main gate line.
Step 8: sintering.

As shown in Figures 4, 5, and 9, the solar cell module comprises at least two bonded cell piece units 1. The cell piece unit 1 comprises a front surface and a back surface. The front surface is provided with a power generation area 2 and a front main gate line 3 disposed at an edge of one side of the power generation area 2. A plurality of thin gate lines 4 is disposed on the power generation area 2, and the thin gate lines 4 are connected to the front main gate line 3. The back surface is provided with a back main gate line 5 and an aluminum back field 6, and the front main gate line 3 and the back main gate line 5 are respectively located on two opposite sides of the cell piece unit 1. The back main gate line 5 of one cell piece unit 1 is bonded and conductively connected to the front main gate line 3 of another cell piece unit 1. In this embodiment, the number of the cell piece units is five, which can be three or more (not limited herein).

In another aspect of the present invention, the solar cell module comprises at least two bonded cell piece units. The cell piece unit comprises a front surface and a back surface. The front surface is provided with a power generation area and a front main gate line disposed at an edge of one side of the power generation area. A plurality of thin gate lines is disposed on the power generation area, and the thin gate lines are connected to the front main gate line. The back surface is provided with a back main gate line and an aluminum back field, and the front main gate line and the back main gate line are respectively located on two opposite sides of the cell piece unit. The back main gate line of one cell piece unit is bonded and conductively connected to the front main gate line of another cell piece unit.

In another aspect of the present invention, the front main gate line is connected to one end of the thin gate lines.

In another aspect of the present invention, the front main gate line of each cell piece unit is overlapped with the back main front lines of the adjacent cell piece units. The width of the overlapped area of two adjacent cell piece units is 1.2-2.5mm.

In another aspect of the present invention, at least two cell piece units are overlapped end to end to form a solar cell piece unit group. The solar cell module comprises at least one cell piece unit group, and each cell piece unit group comprises 2-50 solar cell piece units.

In another aspect of the present invention, the solar cell module comprises at least two cell piece unit groups. Interconnect busbars are disposed between the cell piece unit groups, through which the cell piece unit groups can be series-connected, parallel-connected, series-connected after a part of the cell piece unit groups are parallel-connected or parallel-connected after a part of the cell piece unit groups are series-connected.

In another aspect of the present invention, lead wires are disposed between the interconnect busbar and the cell piece unit group. A portion of the lead wire is electrically connected to the front main gate line or the back main gate line of the cell piece unit located at the outermost area of the cell piece unit group, and the other portion of the lead wire, which extends outwardly to a direction away from the cell piece unit group, is electrically connected to the interconnect busbar.

In another aspect of the present invention, the width of the connection portion of the interconnect busbar and the main gate line of the cell piece unit is 1-8mm.

In another aspect of the present invention, a portion of the interconnect busbar, which serves as the lead wire, is folded onto the back surface of the cell piece unit group. An insulating layer is disposed between the interconnect busbar and the back surface of the solar cell piece group, through which the interconnect busbar and the back surface of the solar cell piece group can be isolated.

In another aspect of the present invention, the interconnect busbar is provided with connection portions and extension portions. The connection portion and the front/back main gate line that is connected to the connection portion are disposed in the same direction. The extension portion is perpendicular to the connection portion, or forms a blunt angle or a sharp angle with the connection portion.

In another aspect of the present invention, each cell piece unit group has at least two connection portions with the lead wire of the front main gate line or that of the back main gate line. The extension portions are further connected to a same main lead wire.

In another aspect of the present invention, the main gate lines disposed at the outermost area of the same side of two adjacent cell piece unit groups have different polarities. Namely, the front main gate lines and the back main gate lines are arranged at intervals, wherein all the front main gate lines and the back main gate lines located on one side are connected to a same main lead wire, and all the front main gate lines located on the other side are connected to a front main gate line main lead wire. All the back main gate lines are connected to a back main gate line main lead wire. The front main gate line main lead wire and the back main gate line main lead wire serve as the master output lead wires of the solar cell module.

In another aspect of the present invention, lead wires connected to the front main gate line of the cell piece unit group or that connected to the back main gate line of the cell piece unit group are bent and folded onto the back surface of the cell piece unit group. The front main gate line main lead wire and the back main gate line main lead wire are disposed on the back surface of the cell piece unit group. Insulating components are disposed between the front main gate line main lead wire, the back main gate line main lead wire and the back surface of the cell piece unit group.

The present invention also provides a method for preparing the above cell piece unit, comprising the steps of:
Step 1: printing: printing the corresponding front screen-printed pattern and back screen-printed pattern on the front surface and the back surface of the silicon chip layer, wherein the front screen-printed pattern comprises thin gate lines and front main gate lines that are perpendicular to the thin gate lines, the front main gate lines are uniformly arranged at intervals along the length direction of the thin gate lines, and an edge of one side of the front screen-printed pattern is provided with front edge main gate lines;
   The back screen-printed pattern comprises back main gate lines and an aluminum back surface field; the back main gate lines and the front main gate lines are uniformly disposed at intervals in the same direction; an edge of one side of the back screen-printed pattern is provided with back edge main gate lines; the front edge main gate lines and the back edge main gate lines are respectively disposed on two opposite sides of the silicon chip layer;
Step 2: cutting: using a cutting apparatus to cut the solar cell piece along a cutting line, thereby forming a plurality of cell piece units, wherein the cutting line is overlapped with the edge of the front main gate line;
Step 3: bonding: applying an electrically conductive bonding material on the front main gate line of a first cell piece unit; subsequently, attaching the back main gate line of a second cell piece unit onto the front main gate line of the first cell piece unit, thereby bonding the two cell piece units; subsequently, bonding a third cell piece unit to the second cell piece unit in the same way; repeating the above step until all the cell piece units are electrically bonded together, thereby completing the preparation of a solar cell piece.

In another aspect of the present invention, the electrically conductive bonding material used in step 3 is either an electrically conductive adhesive or a soldering paste.

In another aspect of the present invention, all the cutting lines in step 2 are located on the same side of the front main gate lines, and are consistent with the outer edge of the front edge main gate lines.

Preparing the solar cell module and the cell piece unit of the present invention relates to a solar cell piece, which comprises an aluminum back field coating, a silicon chip layer and thin gate lines. A front surface of the solar cell piece is partitioned into at least two independent areas, at least one front main gate line being disposed at an edge of one side of each area or a position close to the edge, all the thin gate lines on the front surface of this area being electrically connected to the front main gate lines of this area. The said independent area is a cell piece unit, which can be used independently after being cut, or can be connected to other cell piece units in series or in parallel through guide lines or lead wires without being cut.

The aforesaid solar cell piece is an essential component for preparing a solar cell module. In a traditional process, the solar cell piece comprises a silicon chip layer, an aluminum back field coating, front thin gate lines, and three or four longitudinal main gate lines. When preparing a solar cell module, the main gate lines of a plurality of solar cell pieces need to be soldered and connected in series by means of solder strips. Meanwhile, all energy conversion units of a traditional solar cell piece are usually connected into an integral body through the thin gate lines and the main gate lines. Each main gate line simultaneously collects the current of the energy conversion units on the left and right sides. The main gate lines of the solar cell piece of the present invention are transversely arranged, thereby partitioning the solar cell piece into at least two independent areas. Each area is provided with one front main gate line, and each main gate line will only collect the current of the energy conversion units in its own area (located on one side of the front main gate line). In order to improve the energy conversion efficiency, such an area is preferred to be as small as possible. Thus, the path from the thin gate lines to the main gate line can be shorter, making the collection and conversion efficiency be higher. Being limited by the production process and cost, the number of the independent areas is preferred to be between two to six. According to the actual requirement, a solar cell piece can be provided with more than seven independent areas. In the process of preparing a solar cell module, the solar cell piece of the present invention has a higher flexibility. For instance, (1) each area can be cut into a plurality of independent solar cell piece units. The solar cell piece units can then be connected in series, and the two ends of the solar cell piece units can be series-connected in a staggered and shingled overlapping manner. When the main gate line of each solar cell piece unit is disposed at the top of each solar cell piece unit, the upper edge of each lower cell piece unit is exactly overlapped with the lower edge of each upper cell piece unit as these cell piece units are arranged from top to bottom and the main gate line of each lower cell piece unit is exactly covered by the lower edge of each upper cell piece unit, enabling the main gate lines of each lower cell piece unit to be connected to the back positive electrode of each upper cell piece unit. In this way, all the cell piece units are series-connected by repeating the above step. Thus, the main gate lines will no longer appear on the front surface of the solar cell module and this eliminates the spaces occupied by the main gate lines. In such a configuration, the effective power-generating area of the whole solar cell module is significantly increased. Meanwhile, it's unnecessary to connect the solar cell pieces via the solder strips, thereby solving problems such as complicated process, high production cost and wastage of effective power-generating area. (2), When the cell piece units are arranged in a staggered and shingled overlapped manner, and the front main gate line of a next cell piece unit is insulated from the back positive electrodes of a previous cell piece unit, the front main gate lines of all the cell piece units are connected on the side surface or on the back surface, and the back positive electrodes of all the cell piece units are connected together. After extracting the back positive electrodes, a solar cell module having a parallel structure (shown in Figure 3) can be achieved. Thus, the circuit structure of the solar cell module can have more combinations. (3), The above two connection methods can be freely combined to form various circuit structures of the solar cell module. (4), The front main gate line in one area can be connected to the back electrodes in another area by means of the connecting wires. Thus, all the areas of the solar cell piece can be first series-connected, parallel-connected or series-parallel connected without being cut. Subsequently, a plurality of solar cell pieces is connected in series, thereby completing the assembly of a solar cell module.

In another aspect of the present invention, the back surface of the solar cell piece corresponds to the front surface area. A back main gate line is disposed at an edge of one side or a position close to the edge which is opposite to the main gate line that is disposed on the corresponding area of the front surface of the solar cell piece. The back main gate line is electrically connected to the back electrodes on the corresponding area of the solar cell piece.

In another aspect of the present invention, an isolation zone, which enables the adjacent areas to be electrically isolated, is provided between adjacent areas on the front surface of the solar cell piece.

In another aspect of the present invention, a portion of the back surface of the solar cell piece, which corresponds to the position of the isolation zone of the front surface, is not provided with the aluminum back field coating.

In another aspect of the present invention, a portion of the back surface of the solar cell piece, which corresponds to the position located between the front surface areas, is provided with line-shaped or strip-like separating lines having no aluminum back field coating.

In another aspect of the present invention, the front main gate lines of the two outermost areas on the front surface of the solar cell piece are disposed at an edge or a position close to the edge of the outermost area of the solar cell piece.

In another aspect of the present invention, the front main gate line comprises soldering portions and connecting portions. The width of the soldering portion is greater than that of the connecting portion. The soldering portions are connected through the connecting portions. The front main gate line is a single through gate line, or two or more separated gate lines.

In another aspect of the present invention, transverse thin gate lines, through which the adjacent thin gate lines are connected, are perpendicular to the thin gate lines, and are disposed between the thin gate lines.

The present invention also provides a method for preparing a solar cell piece of claim 1 or 2, comprising the following steps:
Step 1: testing the silicon chip layer;
Step 2: texturing the surface of the silicon chip layer;
Step 3: performing a diffusion to form a P-N Junction;
Step 4: removing the phosphorus silicon glass;
Step 5: removing the P-N junction on the edges of the cell piece;
Step 6: preparing an antireflection film;
Step 7: preparing the positive and negative electrodes, which comprises the steps of:
   a) printing the front electrodes: printing the corresponding front screen-printed pattern on the front surface of the silicon chip layer, wherein the front screen-printed pattern separates the solar cell piece into at least two areas, and each area comprises the thin gate lines and the front main gate line that is connected to the thin gate lines, the front main gate lines in different areas being arranged in parallel at intervals, and the main gate lines of the two edge areas of the solar cell piece being respectively disposed on the edge or close to the edge of the solar cell piece;
   b) printing the aluminum back surface field: printing the corresponding back screen-printed pattern on the back surface of the silicon chip, wherein the back screen-printed pattern comprises the back main gate lines and the aluminum back surface field, the back main gate line and the front main gate line being arranged in parallel, each area corresponding to the front surface being provided with a back main gate line, the back main gate line in each area being disposed on one side far from the front main gate line.
Step 8: sintering.

As shown in Figures 4, 5, and 9, the solar cell module comprises at least two bonded cell piece units 1. The cell piece unit 1 comprises a front surface and a back surface. The front surface is provided with a power generation area 2 and a front main gate line 3 disposed at an edge of one side of the power generation area 2. A plurality of thin gate lines 4 is disposed on the power generation area 2, and the thin gate lines 4 are connected to the front main gate line 3. The back surface is provided with a back main gate line 5 and an aluminum back field 6, and the front main gate line 3 and the back main gate line 5 are respectively located on two opposite sides of the cell piece unit 1. The back main gate line 5 of one cell piece unit 1 is bonded and conductively connected to the front main gate line 3 of another cell piece unit 1. In this embodiment, the number of the cell piece units is five, which can be three or more (not limited herein).

After adopting the above technical solution, the present invention has the following advantages: the main gate line structure soldered by the solder strips no longer appears on the front surface of the solar cell piece because the solar cell piece is formed by bonding a plurality of cell piece units 1. Consequently, the light no longer be blocked by these solder strips, greatly improving the light-receiving area and the power-generating efficiency of the solar cell piece. Meanwhile, the solar cell piece formed by bonding a plurality of cell piece units 1 can effectively reduce the current of the short-circuit and the loss of fill factors, which in turn significantly enhances the output efficiency of the solar cell piece. Furthermore, a cell string can be directly formed when the number of the cell piece units 1 that are bonded together is sufficient (e.g., 20 pcs or more). It's unnecessary to solder the cell piece units 1 via the solder strips, greatly improving the production efficiency. Moreover, the hidden defects (e.g., insufficient soldering or weak soldering) caused by the traditional soldering process of the cell string can be overcome, greatly enhancing the overall quality of the cell pieces and the cell string.

Based on the above technical solution, the present invention can be further optimized as the following:

As shown in Figures 4 and 9, in some other embodiments of the solar cell piece of the present invention, the front main gate line 3 is connected to one end of the thin gate lines 4.

The aforesaid technical solution allows the thin gate lines 4 to be converged at one end, which can be conveniently bonded to various cell piece units 1.

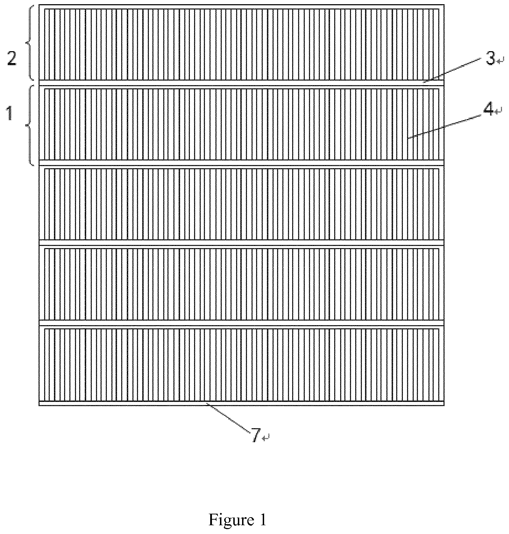

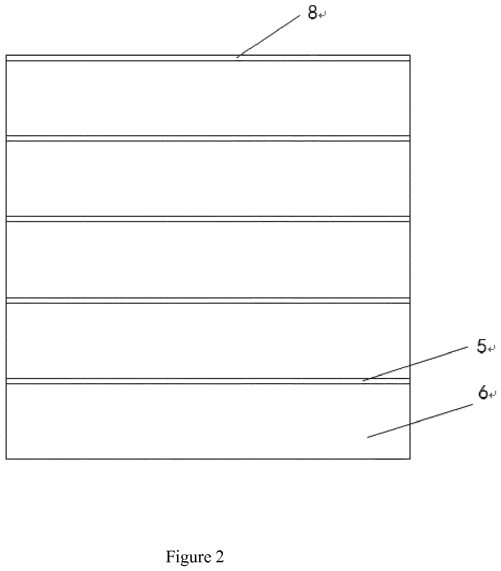

To achieve the purpose of the present invention, in some other embodiments of preparing the above solar cell piece of the present invention, namely, the cell piece consisted of five cell piece units 1, comprising the following steps of:
Step 1: printing: as shown in Figures 1 and 2, printing the corresponding front screen-printed pattern and the back screen-printed pattern on the front surface and the back surface of the silicon chip layer, wherein the front screen-printed pattern comprises thin gate lines 4 and front main gate lines 3 that are perpendicular to the thin gate lines 4, the front main gate lines 3 being uniformly arranged at intervals along the length direction of the thin gate lines 4, an edge of one side of the front screen-printed pattern being provided with the front edge main gate line 7;
   The back screen-printed pattern comprises back main gate lines 5 and an aluminum back surface field 6; the back main gate lines 5 and the front main gate lines 3 are disposed in the same direction, and are uniformly arranged at intervals; an edge of one side of the back screen-printed pattern is provided with the back edge main gate line 8; the front edge main gate lines 7 and the back edge main gate lines 8 are respectively disposed on two opposite sides of the silicon chip layer;
Step 2: cutting: as shown in Figure 3, cutting the silicon chip layer through a cutting apparatus along a cutting line 9, thereby forming a plurality of the cell piece units 1, wherein as shown in Figures 4 and 5, the cutting line 9 is overlapped with the edge of the front main gate line 3, and the cutting apparatus is a laser cutting apparatus or other cutting apparatuses;
Step 3: bonding: as shown in Figures 6 and 7, applying an electrically conductive bonding material 10 on the front main gate line 3 of the first cell piece unit 1, and bonding the back main gate line 5 of the second cell piece unit 1 to the front main gate line 3 of the first cell piece unit 1, thereby allowing the two cell piece units to be bonded together as shown in Figure 8; subsequently, bonding the third cell piece unit to the second cell piece unit in the same way; repeating the above step until the five cell piece units 1 are electrically bonded together, thereby completing the preparation of the solar cell piece shown in Figure 9.

After adopting the above technical solution, the present invention has the following advantages:

The screen-printed patterns of a plurality of solar cell piece units 1 is printed on the silicon chip layer first. Subsequently, the silicon chip layer is cut into a plurality of solar cell piece units 1. Finally, these solar cell piece units 1 are electrically bonded together. Such a process can greatly improve the production efficiency. Meanwhile, the light-receiving area of the solar cell pieces prepared by this method can be significantly increased, thereby enhancing the power generation efficiency of the solar cell pieces.

Based on the above technical solution, the present invention can be further optimized as the following:

To further optimize the implementation effect of the present invention, as shown in Figure 6, in some other embodiments of the solar cell piece of the present invention, the conductive bonding material 10 used in step 3 can be an electrically conductive adhesive or a soldering paste. During the bonding process, the solar cell piece units are bonded via infrared bonding equipment, wave-soldering equipment or reflow-soldering equipment.

According to the above technical solution, various cell piece units are bonded through the conductive adhesive or the soldering paste which can ensure the connection force and electrical conductivity between two cell piece units are established.

To further optimize the implementation effect of the present invention, as shown in Figure 3, in some other embodiments of the solar cell piece of the present invention, the cutting lines 9 in step 2 are all disposed on the same side with the front gate lines 3, and are consistent with the outer edge of the front edge main gate lines 7. The cutting lines 9 are all disposed at the lower edge of the front main gate lines 3, and are consistent with the outer edge of the front edge main gate lines 7.

After adopting the above technical solution, the solar cell piece can be rapidly cut, greatly improving the cutting efficiency. Meanwhile, waste products that are produced during the cutting process can be reduced, effectively improving the utilization rate of the raw materials.

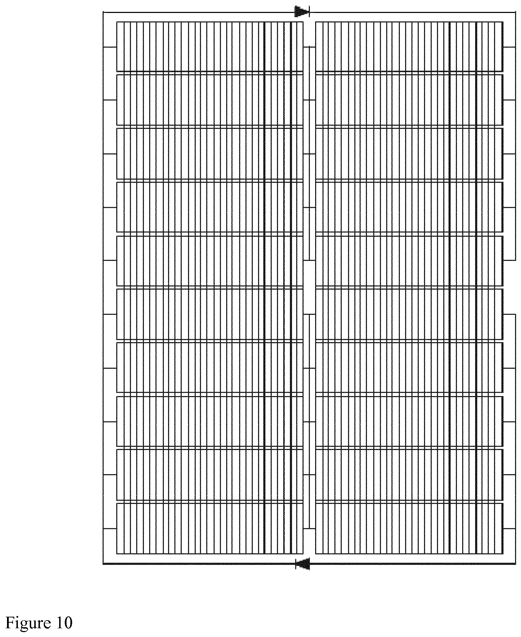

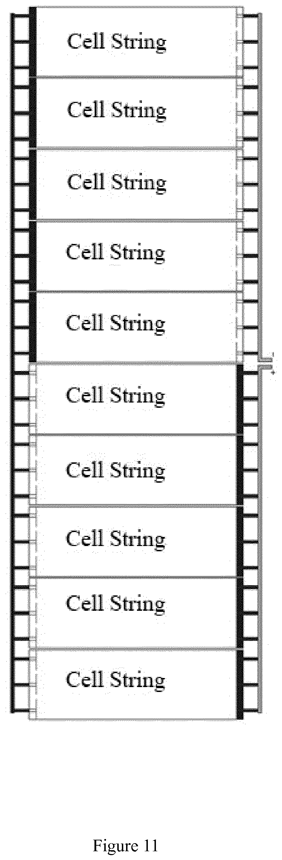

When the number of the cell piece units is sufficient for preparing a cell string, the cell string can be directly made because the solar cell piece is formed by bonding a plurality of the cell piece units. The type of the cell string can be various, thereby allowing different cell strings to be connected in series or in parallel to form different solar cell modules as shown in Figures 10 and 11. Such solar cell modules can correspond to various electric output parameters, which have a higher applicability.

As described above, to prepare the above cell piece unit, a traditional silicon chip layer must be first printed with the front and back main gate lines according to the design of the present invention, which is subsequently cut into a plurality of cell piece units. Such a process is repeated hereinafter:

The above solar cell piece comprises an aluminum back field coating, a silicon chip layer and thin gate lines. A front surface of the solar cell piece is partitioned into at least two independent areas, at least one front main gate line being disposed at an edge of one side of each area or a position close to the edge, all the thin gate lines on the front surface of this area being electrically connected to the front main gate lines of this area.

The aforesaid solar cell piece is an essential component for preparing a solar cell module. In a traditional process, the solar cell piece comprises a silicon chip layer, an aluminum back field coating, front thin gate lines, and three or four longitudinal main gate lines. When preparing a solar cell module, the main gate lines of a plurality of solar cell pieces need to be soldered and connected in series by means of solder strips. Meanwhile, all energy conversion units of a traditional solar cell piece are usually connected into an integral body through the thin gate lines and the main gate lines. Each main gate line simultaneously collects the current of the energy conversion units on the left and right sides. The main gate lines of the solar cell piece of the present invention are transversely arranged, thereby partitioning the solar cell piece into at least two independent areas. Each area is provided with one front main gate line, and each main gate line will only collect the current of the energy conversion units in its own area (located on one side of the front main gate line). In order to improve the energy conversion efficiency, such an area is preferred to be as small as possible. Thus, the path from the thin gate lines to the main gate line can be shorter, making the collection and conversion efficiency be higher. Being limited by the production process and cost, the number of the independent areas are preferred to be between two to six. According to the actual requirement, a solar cell piece can be provided with more than seven independent areas. In the process of preparing a solar cell module, the solar cell piece of the present invention has a higher flexibility. For instance, (1) each area can be cut into a plurality of independent solar cell piece units. The solar cell piece units can then be connected in series, and the two ends of the solar cell piece units can be series-connected in a staggered and shingled overlapping manner. When the main gate line of each solar cell piece unit is disposed at the top of each solar cell piece unit, the upper edge of each lower cell piece unit is exactly overlapped with the lower edge of each upper cell piece unit as these cell piece units are arranged from top to bottom and the main gate line of each lower cell piece unit is exactly covered by the lower edge of each upper cell piece unit, enabling the main gate lines of each lower cell piece unit to be connected to the back positive electrode of each upper cell piece unit. In this way, all the cell piece units are series-connected by repeating the above step. Thus, the main gate lines will no longer appear on the front surface of the solar cell module and this eliminates the spaces occupied by the main gate lines. In such a configuration, the effective power-generating area of the whole solar cell module is significantly increased. Meanwhile, it's unnecessary to connect the solar cell pieces via the solder strips, thereby solving problems such as complicated process, high production cost and wastage of effective power-generating area. (2) When the cell piece units are arranged in a staggered and shingled overlapped manner, and the front main gate line of a next cell piece unit is insulated from the back positive electrodes of a previous cell piece unit, the front main gate lines of all the cell piece units are connected on the side surface or on the back surface, and the back positive electrodes of all the cell piece units are connected together. After extracting the back positive electrodes, a solar cell module having a parallel structure (shown in Figure 3) can be achieved. Thus, the circuit structure of the solar cell module can have more combinations. (3) The above two connection methods can be freely combined to form various circuit structures of the solar cell module. (4) The front main gate line in one area can be connected to the back electrodes in another area by means of the connecting wires. Thus, all the areas of the solar cell piece can be first series-connected, parallel-connected or series-parallel connected without being cut. Subsequently, a plurality of solar cell pieces is connected in series, thereby completing the assembly of a solar cell module.

As shown in Figures 4, 5 and 9, in some embodiments of the solar cell piece of the present invention, the solar cell piece is cut into a plurality of independent cell piece units by areas. In specific applications, each solar cell module comprises at least two cell piece units 1 that are bonded together. The cell piece unit 1 comprises a front surface and a back surface. The front surface of the cell piece unit is provided with a power-generating area 2 and a front main gate line 3 that is disposed at an edge of one side of the power-generating area 2. The power-generating area 2 is provided with a plurality of thin gate lines 4, and the thin gate lines 4 are connected to the front main gate line 3. The back surface of the cell piece unit is provided with a back main gate line 5 and an aluminum back surface field 6. The front main gate line 3 and the back main front line 5 are respectively disposed on two opposite sides of the cell piece unit 1, wherein the back main gate line 5 of one cell piece unit 1 is bonded to and electrically connected to the front main gate line 3 of another cell piece unit. In other words, when two cell piece units 1 are bonded, the front main gate line 3 of one cell piece unit can simply be bonded to the back main gate line 5 of the other cell piece unit. In this embodiment, the number of the cell piece units is five. The number of cell piece units can be three or more, which is not restricted herein.

After adopting the above technical solution, the present invention has the following advantages: the main gate line structure soldered by the solder strips will no longer appear on the front surface of the solar cell piece because the solar cell piece is formed by bonding a plurality of cell piece units 1. Consequently, the light is no longer blocked by these solder strips, greatly improving the light-receiving area and the power-generating efficiency of the solar cell piece. Meanwhile, the solar cell piece formed by bonding a plurality of cell piece units 1 can effectively reduce the current of the short-circuit and the loss of fill factors, which significantly enhances the output efficiency of the solar cell piece. Furthermore, a cell string can be directly formed when the number of the cell piece units 1 that are bonded together is sufficient (e.g., 20 pcs or more). It's unnecessary to solder the cell piece units 1 via the solder strips, greatly improving the production efficiency. Moreover, the hidden defects (e.g., insufficient soldering or weak soldering) caused by the traditional soldering process of the cell string can be overcome, greatly enhancing the overall quality of the cell pieces and the cell string.

Based on the above technical solution, the present invention can be further optimized as the following:

As shown in Figures 4 and 9, in some other embodiments of the solar cell piece of the present invention, the front main gate line 3 is connected to one end of the thin gate lines 4.

The aforesaid technical solution allows the thin gate lines 4 to be converged at one end, which can be conveniently bonded to various cell piece units 1.

To achieve the purpose of the present invention, in some other embodiments of preparing the above solar cell piece of the present invention, namely, the cell piece consisted of five cell piece units 1, comprising the following steps of:
Step 1: printing: as shown in Figures 1 and 2, printing the corresponding front screen-printed pattern and the back screen-printed pattern on the front surface and the back surface of the silicon chip layer, wherein the front screen-printed pattern comprises thin gate lines 4 and front main gate lines 3 that are perpendicular to the thin gate lines 4, the front main gate lines 3 being uniformly arranged at intervals along the length direction of the thin gate lines 4, an edge of one side of the front screen-printed pattern being provided with the front edge main gate line 7;
   The back screen-printed pattern comprises back main gate lines 5 and an aluminum back surface field 6; the back main gate lines 5 and the front main gate lines 3 are disposed in the same direction, and are uniformly arranged at intervals; an edge of one side of the back screen-printed pattern is provided with the back edge main gate line 8; the front edge main gate lines 7 and the back edge main gate lines 8 are respectively disposed on two opposite sides of the silicon chip layer;
Step 2: cutting: as shown in Figure 3, cutting the silicon chip layer through a cutting apparatus along a cutting line 9, thereby forming a plurality of the cell piece units 1, wherein as shown in Figures 4 and 5, the cutting line 9 is overlapped with the edge of the front main gate line 3, and the cutting apparatus is a laser cutting apparatus or other cutting apparatuses;
Step 3: bonding: as shown in Figures 6 and 7, applying a conductive bonding material 10 on the front main gate line 3 of the first cell piece unit 1, and bonding the back main gate line 5 of the second cell piece unit 1 to the front main gate line 3 of the first cell piece unit 1, thereby allowing the two cell piece units to be bonded together as shown in Figure 8; subsequently, bonding the third cell piece unit to the second cell piece unit in the same way; repeating the above step until the five cell piece units 1 are electrically bonded together, thereby completing the preparation of the solar cell piece shown in Figure 9.

After adopting the above technical solution, the present invention has the following advantages:

The screen-printed patterns of a plurality of solar cell piece units 1 is printed on the silicon chip layer first. Subsequently, the silicon chip layer is cut into a plurality of solar cell piece units 1. Finally, these solar cell piece units 1 are bonded together. Such a process can greatly improve the production efficiency. Meanwhile, the light-receiving area of the solar cell pieces prepared by this method can be significantly increased, thereby enhancing the power generation efficiency of the solar cell pieces.

Based on the above technical solution, the present invention can be further optimized as the following:

To further optimize the implementation effect of the present invention, as shown in Figure 6, in some other embodiments of the solar cell piece of the present invention, the conductive bonding material 10 used in step 3 can be an electrically conductive adhesive or a soldering paste. During the bonding process, the solar cell piece units are bonded via infrared bonding equipment, wave-soldering equipment or reflow-soldering equipment.

According to the above technical solution, various cell piece units are bonded through the conductive adhesive or the soldering paste which can ensure the connection force and electrical conductivity between two cell piece units are established.

To further optimize the implementation effect of the present invention, as shown in Figure 3, in some other embodiments of the solar cell piece of the present invention, the cutting lines 9 in step 2 are all disposed on the same side with the front gate lines 3, and are consistent with the outer edge of the front edge main gate lines 7. The cutting lines 9 are all disposed at the lower edge of the front main gate lines 3, and are consistent with the outer edge of the front edge main gate lines 7.

After adopting the above technical solution, the solar cell piece can be rapidly cut, greatly improving the cutting efficiency. Meanwhile, waste products that are produced during the cutting process can be reduced, effectively improving the utilization rate of the raw materials.

When the number of the cell piece units is sufficient for preparing a cell string, the cell string can be directly made because the solar cell piece is formed by bonding a plurality of the cell piece units. The type of the cell string can be various, thereby allowing different cell strings to be connected in series or in parallel to form different solar cell modules as shown in Figures 10 and 11. Such solar cell modules can correspond to various electric output parameters, which have a higher applicability.

In some embodiments, the back surface of the solar cell piece corresponds to the front surface area. A back main gate line is disposed at an edge of one side or a position close to the edge which is opposite to the main gate line that is disposed in the corresponding area of the front surface of the solar cell piece. The back main gate line is electrically connected to the back electrodes in the corresponding area of the solar cell piece. Such a design is convenient to connect the back electrodes. No matter whether all areas are connected only after being cut, or connected through connecting wires without being cut, the specific back main gate lines are more convenient for the soldering process, which can effectively avoid the bad connection.

In another aspect of the present invention, in some embodiments, an isolation zone, which enables the adjacent areas to be electrically isolated, is provided between the adjacent areas on the front surface of the solar cell piece. It not only can electrically isolate all the areas, but can also allow the areas to be cut conveniently along the isolation line when necessary.

In another aspect of the present invention, a portion of the back surface of the solar cell piece, which corresponds to the position of the isolation zone on the front surface, is not provided with aluminum back field coating. Such a design can electrically isolate the back electrodes of all the areas, achieving a complete isolation between them. In a non-cutting application, all the areas can be conveniently connected in series or in parallel. Furthermore, the isolation line is not provided with the aluminum back field coating, effectively preventing metal burrs from happening during the cutting process. Consequently, the grinding time can be saved, and the production efficiency can be improved.

In another aspect of the present invention, a portion of the back surface of the solar cell piece, which corresponds to the position between the front surface areas, is provided with line-shaped or strip-like separating lines having no aluminum back field coating. After printing the separating lines, the solar cell piece can be easily cut, which can reduce the waste products produced during the cutting process.

In another aspect of the present invention, the front main gate lines of the two outermost areas of the front surface of the solar cell piece are disposed at an edge or a position close to the edge of the outermost portion of the solar cell piece. With regards to the fabrication process of the solar cell piece, the four corners of the solar cell piece can be arced or linear chamfered. After being cut into a plurality of areas, the cell piece units formed by the areas of the two ends of the solar cell piece can have two chamfers, and the cell piece units in the middle area are rectangle-shaped. When the edge of the chamfer is provided with a back main gate line, the chamfer is overlapped with the upper surface of another cell piece unit once the two cell piece units are series-connected in an overlapped manner. As a result, the chamfered part of the cell piece unit is exteriorly exposed, resulting in an unpleasant appearance from the front surface of the solar cell module. After adopting the technical solution of the present invention, the edge having the chamfer can always be covered by one side of another cell piece unit having a right angle. Thus, the appearance of the whole solar cell module can be good-looking, beautiful and consistent.

In another aspect of the present invention, the front main gate line comprises a soldering portion and a connecting portion. The width of the soldering portion is greater than that of the connecting portion. The soldering portions are connected through the connecting portions. The front main gate line is either a single through-line, or a plurality of separated gate lines. Thus, the width of the front main gate lines can be various, effectively saving the cost.

In another aspect of the present invention, transverse thin gate lines, which connect the adjacent thin gate lines, and are perpendicular to the thin gate lines, are disposed between the thin gate lines. Such a configuration can allow the current of each power unit that is being collected by the adjacent thin gate lines to flow through the transverse thin gate line when one of the thin gate lines is broken.

The present invention also provides a method for preparing a solar cell piece of claim 1 or 2, comprising the following steps:
Step 1: testing the silicon chip layer;
Step 2: texturing the surface of the silicon chip layer;
Step 3: performing a diffusion to form a P-N Junction;
Step 4: removing the phosphorus silicon glass;
Step 5: removing the P-N junction on the edges of the cell piece;
Step 6: preparing an antireflection film;
Step 7: preparing the positive and negative electrodes, which comprises the steps of:
   a) printing the front electrodes: printing the corresponding front screen-printed pattern on the front surface of the silicon chip layer, wherein the front screen-printed pattern separates the solar cell piece into at least two areas, and each area comprises the thin gate lines and the front main gate line that is connected to the thin gate lines, the front main gate lines in different areas being arranged in parallel at intervals, and the main gate lines of the two edge areas of the solar cell piece being respectively disposed on the edge or close to the edge of the solar cell piece;
   b) printing the aluminum back surface field: printing the corresponding back screen-printed pattern on the back surface of the silicon chip layer, wherein the back screen-printed pattern comprises the back main gate lines and the aluminum back surface field, the back main gate line and the front main gate line being arranged in parallel, each area corresponding to the front surface being provided with a back main gate line, the back main gate line in each area being disposed on one side far from the front main gate line.
Step 8: sintering.

The solar cell piece in above embodiments can be prepared according to the method of the present invention, which can be cut into a plurality of cell piece units. The front main gate lines and the back electrodes of all the areas can be connected first through the connecting wires or other means. Subsequently, the solar cell pieces can be connected to form the solar cell module of the present invention.

The description of above embodiments allows those skilled in the art to realize or use the present invention. Without departing from the spirit and essence of the present invention, those skilled in the art can combine, change or modify correspondingly according to the present invention. Therefore, the protective range of the present invention should not be limited to the embodiments above but conform to the widest protective range which is consistent with the principles and innovative characteristics of the present invention. Although some special terms are used in the description of the present invention, the scope of the invention should not necessarily be limited by this description. The scope of the present invention is defined by the claims.

## Claims

1. A solar cell module, comprising:
at least one solar cell piece unit group that is arranged in the longitudinal or transverse direction, wherein each solar cell piece unit group comprising at least two cell piece units, wherein the cell piece units connected in one string are sequentially arranged in an overlapped manner, wherein each cell piece unit comprises a front surface and a back surface, wherein the front surface is provided with a power generation area and front main gate lines disposed at an edge of one side of the power generation area, wherein a plurality of thin gate lines is disposed on the power generation area, and the thin gate lines are connected to the front main gate lines, wherein the back surface is provided with back main gate lines and an aluminum back field, and the front main gate lines and the back main gate lines are located on two opposite sides of the cell piece unit, wherein the front main gate line and the back main gate line of each cell piece unit are respectively bonded and conductively connected to the back main gate line of one adjacent cell piece unit, and the front main gate line of the other adjacent cell piece unit.

2. The solar cell module of claim 1, comprising:
at least two bonded cell piece units, wherein the cell piece unit comprises a front surface and a back surface, wherein the front surface is provided with a power generation area and a front main gate line disposed at an edge of one side of the power generation area, wherein a plurality of thin gate lines is disposed on the power generation area, and the thin gate lines are connected to the front main gate line, wherein the back surface is provided with a back main gate line and an aluminum back field, wherein the front main gate line and the back main gate line are respectively located on two opposite sides of the cell piece unit, wherein the back main gate line of one cell piece unit are bonded and conductively connected to the front main gate line of another cell piece unit.

3. The solar cell module of claim 2, wherein the front main gate line is connected to one end of the thin gate lines.

4. The solar cell module of claim 1, wherein the front main gate line of each cell piece unit is overlapped with the back main front lines of the adjacent cell piece units, wherein the width of the overlapped area of two adjacent cell piece units is 1.2-2.5mm.

5. The solar cell module of claim 4, wherein at least two cell piece units are overlapped end to end to form a solar cell piece unit group, wherein the solar cell module comprises at least one cell piece unit group, wherein each cell piece unit group comprises 2-80 solar cell piece units.

6. The solar cell module of claim 5, wherein the solar cell module comprises at least two cell piece unit groups, wherein interconnect busbars are disposed between the cell piece unit groups, through which the cell piece unit groups can be series-connected, parallel-connected, series-connected after a part of the cell piece unit groups are parallel-connected or parallel-connected after a part of the cell piece unit groups are series-connected.

7. The solar cell module of claim 6, wherein lead wires are disposed between the interconnect busbar and the cell piece unit group, wherein a portion of the lead wire is electrically connected to the front main gate line or the back main gate line of the cell piece unit located at the outermost area of the cell piece unit group, and the other portion of the lead wire, which extends outwardly to a direction away from the cell piece unit group, is electrically connected to the interconnect busbar.

8. The solar cell module of claim 6, wherein the width of the connection portion of the interconnect busbar and the main gate line of the cell piece unit is 1-8mm.

9. The solar cell module of claim 7, wherein a portion of the interconnect busbar, which serves as the lead wire, is folded onto the back surface of the cell piece unit group, wherein an insulating layer is disposed between the interconnect busbar and the back surface of the solar cell piece group, through which the interconnect busbar and the back surface of the solar cell piece group can be isolated.

10. The solar cell module of claim 7, wherein the interconnect busbar is provided with connection portions and extension portions, wherein the connection portion and the front/back main gate line that is connected to the connection portion are disposed in the same direction, wherein the extension portion is perpendicular to the connection portion, or forms a blunt angle or a sharp angle with the connection portion.

11. The solar cell module of claim 10, wherein each cell piece unit group has at least two connection portions with the lead wire of the front main gate line or that of the back main gate line, wherein the extension portions are further connected to a same main lead wire.

12. The solar cell module of claim 11, wherein the main gate lines disposed at the outermost area of the same side of two adjacent cell piece unit groups have different polarities, namely, the front main gate lines and the back main gate lines are arranged at intervals, wherein all the front main gate lines and the back main gate lines located on one side are connected to a same main lead wire, and all the front main gate lines located on the other side are connected to a front main gate line main lead wire, wherein all the back main gate lines are connected to a back main gate line main lead wire, wherein the front main gate line main lead wire and the back main gate line main lead wire serve as the master output lead wires of the solar cell module.

13. The solar cell module of claim 12, wherein lead wires connected to the front main gate line of the cell piece unit group or that is connected to the back main gate line of the cell piece unit group are bent and folded onto the back surface of the cell piece unit group, wherein the front main gate line main lead wire and the back main gate line main lead wire are disposed on the back surface of the cell piece unit group, wherein insulating components are disposed between the front main gate line main lead wire, the back main gate line main lead wire and the back surface of the cell piece unit group.

14. A method for preparing the cell piece unit according to any one of claims 1-13, comprising the steps of:
Step 1: printing: printing the corresponding front screen-printed pattern and back screen-printed pattern on the front surface and the back surface of the silicon chip layer, wherein the front screen-printed pattern comprises thin gate lines and front main gate lines that are perpendicular to the thin gate lines, the front main gate lines are uniformly arranged at intervals along the length direction of the thin gate lines, and an edge of one side of the front screen-printed pattern is provided with front edge main gate lines; wherein
the back screen-printed pattern comprises back main gate lines and an aluminum back surface field, wherein the back main gate lines and the front main gate lines are uniformly disposed at intervals in the same direction, wherein an edge of one side of the back screen-printed pattern is provided with back edge main gate lines, wherein the front edge main gate lines and the back edge main gate lines are respectively disposed on two opposite sides of the silicon chip layer;
Step 2: cutting: using a cutting apparatus to cut the solar cell piece along a cutting line, thereby forming a plurality of cell piece units, wherein the silicon chip layer is cut into a plurality of independent cell piece units along the cutting line;
Step 3: bonding: applying an electrically conductive bonding material on the front main gate line of a first cell piece unit; subsequently, attaching the back main gate line of a second cell piece unit onto the front main gate line of the first cell piece unit, thereby bonding the two cell piece units; subsequently, bonding a third cell piece unit to the second cell piece unit in the same way; repeating the above step until all the cell piece units are electrically bonded together, thereby completing the preparation of a solar cell piece.

15. The method for preparing cell piece unit according to claim 14, wherein the conductive bonding material used in step 3 is an electrically conductive adhesive, or a soldering paste, or an electrically conductive tape, or a solder strip.
